# EUROPEAN PATENT APPLICATION

(11) **EP 4 617 827 A1**
(43) Date of publication of application: **17.09.2025**
(21) Application number: 25163683.3
(22) Date of filing: 14.03.2025
(51) Int. Cl.: G06F 1/26, G06F 1/30

(54) **POWER BALANCING DEVICE, OPERATING METHOD THEREOF AND RELEVANT RACK-BASED POWER SYSTEM**

(30) Priority: 15.03.2024 US 202463566063 P
(71) Applicant: DELTA ELECTRONICS, INC., Taoyuan City 320023 (TW)
(72) Inventor: CHENG, Hsieh-Hsiung, 320023 Taoyuan City (TW); PENG, Te-Chih, 32063 Taoyuan City (TW); LO, Ming-Hsiang, 32063 Taoyuan City (TW); CHANG, Chao-Fong, 320023 Taoyuan City (TW); WU, Chih-Hong, 32063 Taoyuan City (TW)
(74) Representative: 2K Patentanwälte Blasberg Kewitz & Reichel

(57) **Abstract**

A rack-based power system is used to supply power to a server (10) through a power busbar (50), and includes a power shelf (20) and a power balancing device (30,30'). The power shelf (20) is used to receive an input power and provides an output current (I_{PSU}) to the power busbar (50) so that the power busbar (50) accordingly transmits a system current (I_{SYS}) to supply power to the server (10). The power balancing device (30,30') receives a bus voltage signal (V_{bus}) from the power busbar (50). When a falling rate of the busbar voltage signal exceeds a discharging voltage threshold (V_{th_DCH}), the power balancing device (30,30') provides a first adjustment current (I_{PCS1}) to the power busbar (50). When a rising rate of the busbar voltage signal exceeds a charging voltage threshold (V_{th_CHG}), the power balancing device (30,30') receives a third adjustment current (I_{PCS3}) from the power busbar (50).

## Description

### BACKGROUND

### Technical Field

The present disclosure relates to a power balancing device, operating method thereof and relevant rack-based power system, and more particularly to a power balancing device capable of dynamically adjusting current according to loading changes, operating method thereof and relevant rack-based power system.

### Description of Related Art

With the development of artificial intelligence (AI) and high-performance computing, the power consumption of components such as graphics processing units (GPUs) and central processing units (CPUs) in servers is also increasing. In response to the increasing demand for high-performance computing, server power supply systems need to cope with higher power requirements, higher heat dissipation requirements, and more stable voltage control requirements, and require more intelligent power management systems to ensure their stable operations.

Servers usually use power supplies to convert AC or DC input power into the DC power required by the server. Large server centers are usually equipped with uninterruptible power supplies (UPSs) to cope with sudden power outages or voltage fluctuations so as to ensure that data is not damaged and that there is sufficient time for backup or shutdown.

Since high-power consumption components in servers often have operations that rapidly increase or decrease power consumption, existing power supplies will rapidly draw current from the input power source to cope with such rapid loading changes in a short period of time, thus causing ripples or voltage drops in the input power source, and causing unnecessary noise in the power supply network. If this phenomenon occurs on multiple servers at the same time, it may cause instability in the entire power supply network and even cause other devices to stop working or be damaged.

### SUMMARY

Therefore, how to design a power balancing device, operating method thereof and relevant rack-based power system to solve the problems and technical bottlenecks in the existing technology has become a critical topic in this field.

In order to solve the above-mentioned problems, the present disclosure provides a power balancing device. The power balancing device is coupled to a server and a power shelf through a power busbar. The power balancing device includes a control circuit, a charging and discharging circuit, and an energy storage unit. The control circuit receives a bus voltage signal from the power busbar. The bus voltage signal is positively correlated with a current value of an output current generated by the power shelf. The charging and discharging circuit is coupled to the control circuit, and receives a discharging enabled signal and a charging enabled signal generated by the control circuit. The energy storage unit is coupled to the charging and discharging circuit. When the control circuit determines that a falling rate of the bus voltage signal exceeds a discharging voltage threshold, the control circuit generates the discharging enabled signal so that the charging and discharging circuit accordingly controls the energy storage unit to provide a first adjustment current to the power busbar to supply power. When the control circuit determines that a rising rate of the bus voltage signal exceeds a charging voltage threshold, the control circuit generates the charging enabled signal so that the charging and discharging circuit accordingly receives a third adjustment current from the power busbar to charge the energy storage unit.

In order to solve the above-mentioned problems, the present disclosure provides a rack-based power system. The rack-based power system supplies power to a server through a power busbar. The rack-based power system includes a power shelf and a power balancing device. The power shelf receives an input power source, and converts the input power source to provide an output current to the power busbar so that the power busbar accordingly transmits a system current to supply power to the server. The power balancing device electrically connects to the power busbar. The power balancing device receives a bus voltage signal from the power busbar through a second signal wire, wherein the bus voltage signal is positively correlated with a current value of the output current. When the power balancing device determines that a falling rate of the bus voltage signal exceeds a discharging voltage threshold, the power balancing device provides a first adjustment current to the power busbar to supply power to the server together with the power shelf. When the power balancing device determines that a rising rate of the bus voltage signal exceeds a charging voltage threshold, the power balancing device receives a third adjustment current from the power busbar.

In order to solve the above-mentioned problems, the present disclosure provides a power balancing method. The power balancing method controls a power balancing device. The power balancing device is coupled to a server and a power shelf through a power busbar. The method includes: receiving, by the power balancing device, a bus voltage signal from the power busbar, wherein the bus voltage signal is positively correlated with a current value of an output current generated by the power shelf; controlling, by a control circuit of the power balancing device, a charging and discharging circuit to configure an energy storage unit of the power balancing device to provide a first adjustment current to the power busbar to supply power when the power balancing device determines that a falling rate of the bus voltage signal exceeds a discharging voltage threshold; controlling, by the control circuit of the power balancing device, the charging and discharging circuit of the power balancing device to receive a third adjustment current from the power busbar to charge the energy storage unit when the power balancing device determines that a rising rate of the bus voltage signal exceeds a charging voltage threshold.

Accordingly, the present disclosure has the following features and advantages: the power balancing device can determine the load status of the server according to at least one of the current command signal acquired from the power shelf and the bus voltage signal acquired from the power busbar. During the loading operation of the server, when the loading change rate increases rapidly so that the rising rate of the current command signal exceeds the discharging current threshold, and/or the falling rate of the bus voltage signal exceeds the discharging voltage threshold, the power balancing device supplies power to the server. During the loading operation of the server, when the loading change rate decreases rapidly so that the falling rate of the current command signal exceeds the charging current threshold, and/or the rising rate of the bus voltage signal exceeds the charging voltage threshold, the power shelf charges the power balancing device, thereby maintaining the power supply stability of the power shelf and its upstream power grid.

It is to be understood that both the foregoing general description and the following detailed description are exemplary, and are intended to provide further explanation of the present disclosure as claimed. Other advantages and features of the present disclosure will be apparent from the following description, drawings, and claims.

### BRIEF DESCRIPTION OF DRAWINGS

The present disclosure can be more fully understood by reading the following detailed description of the embodiment, with reference made to the accompanying drawing as follows:
FIG. 1 is a schematic diagram of a rack according to an embodiment of the present disclosure.
FIG. 2 is a block diagram of a rack-based power system according to an embodiment of the present disclosure.
FIG. 3 is a block diagram of the rack-based power system according to another embodiment of the present disclosure.
FIG. 4 is a block diagram of the rack-based power system according to further another embodiment of the present disclosure.
FIG. 5 is a schematic diagram of transmitting a power command signal from a power shelf to a power balancing device according to the present disclosure.
FIG. 6 is a block circuit diagram of a power supply unit of the power shelf and a power balancing device according to an embodiment of the present disclosure.
FIG. 7 is a block circuit diagram of a charging and discharging control of the power balancing device according to an embodiment of the present disclosure.
FIG. 8A is a schematic diagram of the rack according to another embodiment of the present disclosure.
FIG. 8B is a block diagram of the rack-based power system according to another embodiment of the present disclosure.
FIG. 8C is a block circuit diagram of the power supply unit of the power shelf and the power balancing device according to another embodiment of the present disclosure.
FIG. 9 is a block circuit diagram of a charging and discharging control of the power balancing device in FIG. 8C according to an embodiment of the present disclosure.
FIG. 10 is a block circuit diagram of a charging and discharging control of the power balancing device in FIG. 8C according to another embodiment of the present disclosure.

### DETAILED DESCRIPTION

Reference will now be made to the drawing figures to describe the present disclosure in detail. It will be understood that the drawing figures and exemplified embodiments of present disclosure are not limited to the details thereof.

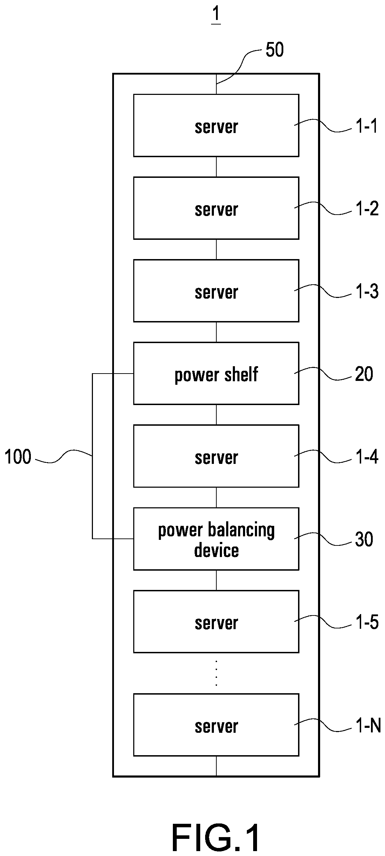

Please refer to FIG. 1, which shows a schematic diagram of a rack according to a first embodiment of the present disclosure. The rack 1 (also referred to as "cabinet") may be used to install a server, power equipment, network equipment, and storage equipment, and may be applied to a data center or an enterprise server room and deployed in a high-density and scalable manner.

As shown in the embodiment of FIG. 1, the rack 1 of the present disclosure is provided with a plurality of servers 1-1 to 1-N (N is a positive integer), a power shelf 20, and a power balancing device 30. The servers 1-1 to 1-N, the power shelf 20 and the power balancing device 30 are electrically connected to a power busbar 50 or other suitable power transmission conductors for power transmission. In addition, the power shelf 20 and the power balancing device 30 are further connected through a physical first signal wire 100, and the power shelf 20 transmits load information to the power balancing device 30 through the first signal wire 100. The server may include suitable circuit components, such as a CPU, a GPU, a memory, a storage device, etc., and may provide one or more functions such as computing, storing, training, and reasoning. The power shelf 20 includes one or more power supply units (PSUs). One or more power supply units of the power shelf 20 may separately or jointly provide one or more functions such as power factor correction, AC-to-DC conversion, DC-to-DC conversion, etc.

In the embodiment of FIG. 1, the servers 1-1 to 1-N, the power shelf 20, and the power balancing device 30 may be implemented in rack units of the same or different sizes. In other embodiments, the configuration of the server, the power shelf, and the power balancing device may also vary according to different design considerations. For example, some servers in the rack may have one or more built-in power supply units, the rack may not have a power shelf but may have power supply units installed in each server, the rack may have multiple power shelves, or the rack may have multiple power balancing devices. In another embodiment in which multiple racks are connected in parallel to transmit power, the power shelf may be disposed only in one or more of the racks, or the power balancing device may be disposed only in one or more of the racks. For example, a power shelf may be installed only on the first rack, and servers may be installed on the second rack to the Mth rack. The power shelf of the first rack supplies power to the second rack to the Mth rack through a power busbar across the racks, and the power balancing device is installed in one or more racks in the first rack to the Mth rack. Therefore, in one embodiment where multiple racks transmit power in parallel, at least one power shelf and at least one power balancing device should be included, and they may be respectively arranged in the same or different racks.

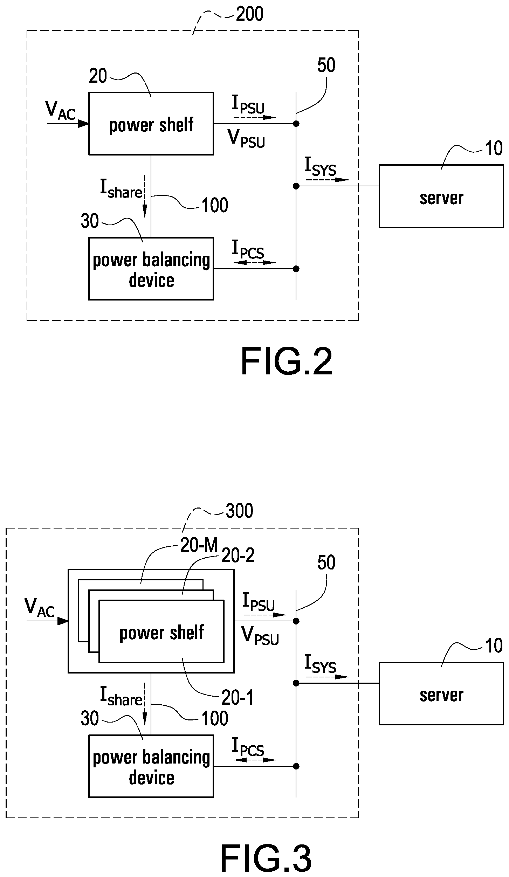

The embodiment of FIG. 2 shows some components of the rack 1, which is a block diagram of a rack-based power system 200. The rack-based power system 200 includes a power busbar 50, a power shelf 20, and a power balancing device 30 for supplying power to a server 10. The server 10, the power shelf 20, and the power balancing device 30 are all connected to the power busbar 50. The power shelf 20 is used to be coupled to an AC input power source to receive an AC input voltage V_{AC}, and convert the AC input voltage V_{AC} to provide an output voltage V_{PSU} and an output current I_{PSU} to the power busbar 50 to supply power to the server 10.

The power shelf 20 generates a current command signal Iₛₕₐᵣₑ according to the provided output current I_{PSU}, and transmits the current command signal Iₛₕₐᵣₑ to the power balancing device 30 through a first signal wire 100. In one embodiment, the current command signal Iₛₕₐᵣₑ is a signal that is positively correlated with a current value of the output current I_{PSU} so that the power balancing device 30 can estimate a load status of the server 10 through the current command signal Iₛₕₐᵣₑ provided by the power shelf 20. For example, when a signal value of the current command signal Iₛₕₐᵣₑ of the power shelf 20 is larger, it means that a loading of the server 10 is higher and more power is required; when the signal value of the current command signal Iₛₕₐᵣₑ of the power shelf 20 is smaller, it means that the loading of the server 10 is lower and less power is required. When a change rate of the signal value of the current command signal Iₛₕₐᵣₑ of the power shelf 20 is relatively large, it means that the loading of the server 10 increases or decreases rapidly.

As shown in the embodiment of FIG. 2, the power shelf 20 provides the output current I_{PSU} to the power busbar 50, and the power busbar 50 transmits a system current I_{SYS} to the server 10 to supply power to the server 10.

The power balancing device 30 provides an adjustment current I_{PCS} to the power busbar 50, or receives the adjustment current I_{PCS} from the power busbar 50. The power balancing device 30 can estimate a load status of the server 10 according to the current command signal Iₛₕₐᵣₑ. When the loading of the server 10 increases rapidly (i.e., the loading increase per unit time exceeds a rising threshold), the power balancing device 30 provides the adjustment current I_{PCS} to the power busbar 50, and together with the power shelf 20 to supply power to the server 10. For example, the system current I_{SYS} transmitted to the server 10 is equal to I_{SYS}=I_{PSU}+I_{PCS}. When the loading of the server 10 decreases rapidly (i.e., the loading decrease per unit time exceeds a falling threshold), the power balancing device 30 receives the adjustment current I_{PCS} from the power busbar 50 to receive the excess current on the power busbar 50. For example, the adjustment current I_{PCS} received by the power balancing device 30 is equal to I_{PCS}=I_{PSU}-I_{SYS}. Therefore, when the loading of the server 10 increases or decreases in a short time, by providing or receiving the adjustment current I_{PCS}, the output current I_{PSU} of the power shelf 20 does not need to increase or decrease rapidly in a short time accordingly so that the power shelf 20 does not need to increase or decrease the current drawn from its input power source rapidly, thereby maintaining the stability of the AC input voltage V_{AC} and the overall power grid.

In the embodiment of FIG. 2, only one of each component is depicted for ease of illustration, and the number of each component may be set to one or more according to different requirements. For example, the embodiment of FIG. 3 shows another embodiment of some components of the rack 1, which is a block diagram of a rack-based power system 300. The server 10 of this embodiment may include a plurality of servers 1-1 to 1-N. In other embodiments, a plurality of power balancing devices 30 may also be provided. The rack-based power system 300 includes a plurality of power shelves 20-1 to 20-M (M is a positive integer). The plurality of power shelves 20-1 to 20-M may be configured and controlled to supply power separately or simultaneously to provide the output current I_{PSU} to the power busbar 50 to supply power to the server 10. For example, the system current I_{SYS} is set to be the sum of the currents provided by one or more power shelves 20 and one or more power balancing devices 30.

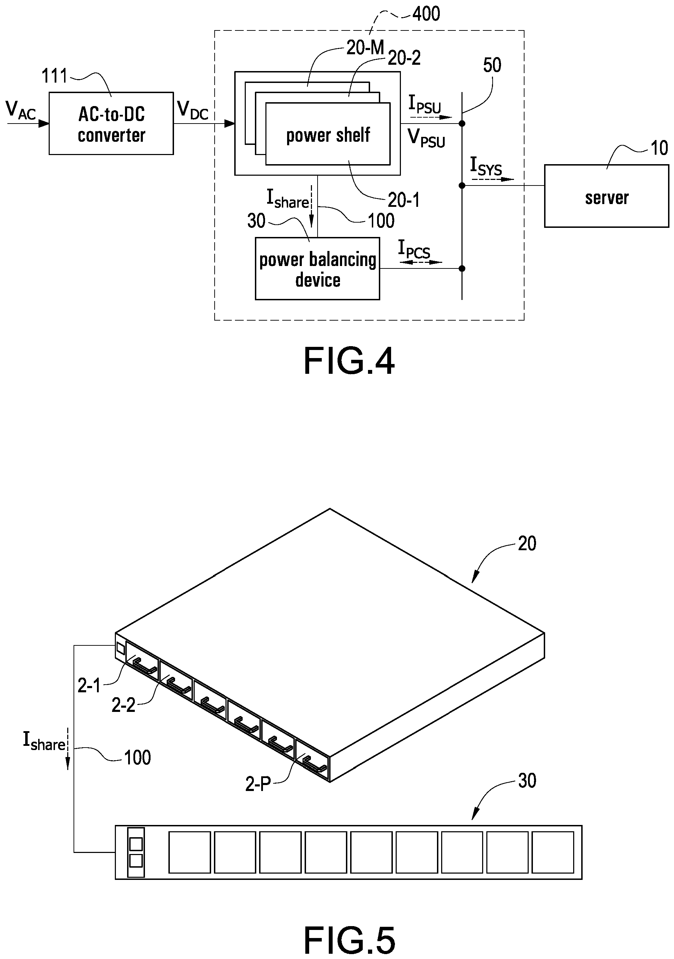

FIG. 4 is another embodiment of a rack-based power system. The rack-based power system 400 of this embodiment includes one or more power shelves 20-1 to 20-M (M is a positive integer), which is used to receive a DC voltage V_{DC} as an input signal from an AC-to-DC converter 111. When the power grid is an AC signal, the AC-to-DC converter 111 is coupled between the AC input power source (such as the power grid) and the power shelves 20-1 to 20-M. The AC-to-DC converter 111 is used to receive an AC input voltage V_{AC} and convert the AC input voltage V_{AC} into the DC voltage V_{DC}. That is, the input power of the rack-based power system may be an AC input power source or a DC input power source, and both can maintain the stability of the input power and the overall power grid.

Please refer to the embodiment of FIG. 5, which is a schematic diagram of transmitting the current command signal Iₛₕₐᵣₑ from the power shelf 20 to the power balancing device 30 according to the present disclosure. As mentioned above, the power shelf 20 and the power balancing device 30 provided in the rack 1 are connected through the first signal wire 100, and therefore the power shelf 20 transmits the current command signal Iₛₕₐᵣₑ to the power balancing device 30 through the first signal wire 100. The power shelf 20 shown in FIG. 5 may include a plurality of power supply units 2-1 to 2-P (P is a positive integer) that are replaceable and support cold/hot swap. For example, the power shelf 20 may include a plurality of power supply units that comply with appropriate specifications such as the Open Compute Project Open Rack Standard Version 3 (OCP ORv3). In another embodiment, part or all of the power supply units of the power shelf 20 are configured to be non-replaceable.

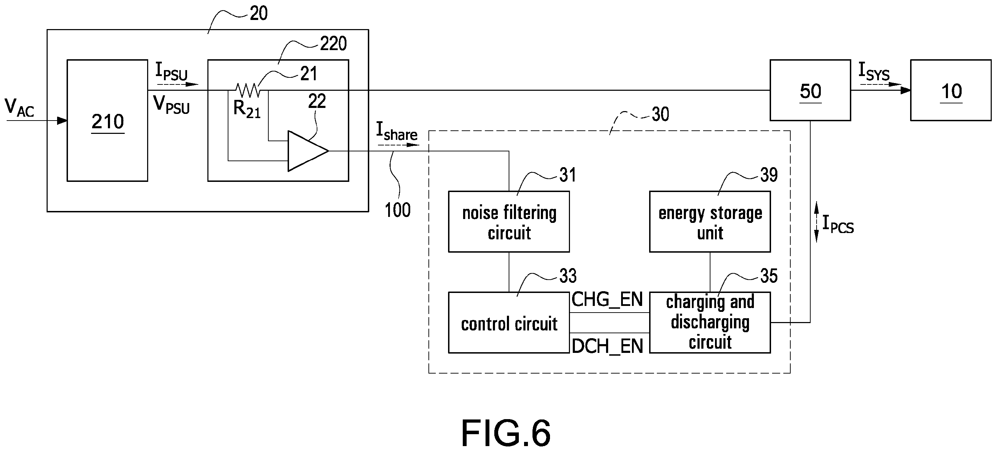

The embodiment of FIG. 6 shows a block circuit diagram of a power supply unit of the power shelf and a power balancing device according to an embodiment of the present disclosure, which includes a power shelf 20 and a power balancing device 30. FIG. 6 only illustrates one power shelf 20, but one or more power shelves 20 configured with one or more power balancing devices 30 may also operate in the same or similar manner. The power shelf 20 in this embodiment includes a power conversion circuit 210 and a load signal generation circuit 220. The power conversion circuit 210 is coupled to the AC input power source to perform appropriate functions such as AC-to-DC conversion or DC-to-DC conversion to generate corresponding output voltage V_{PSU} and output current I_{PSU}. The load signal generation circuit 220 is coupled to an output terminal of the power conversion circuit 210, and generates a corresponding current command signal Iₛₕₐᵣₑ according to the output current I_{PSU}.

In this embodiment, the load signal generation circuit 220 includes a resistor 21 and a gain component 22. The resistor 21 is connected to an output path of the power conversion circuit 210 in series, and a voltage across the resistor 21 is equal to R₂₁*I_{PSU}, where R₂₁ is a resistance value of the resistor 21. The gain component 22 is coupled to both terminals of the resistor 21, and generates a current command signal Iₛₕₐᵣₑ according to a voltage across both terminals of the resistor 21 and a suitable multiplication factor. The multiplication factor may be greater than or less than 0, and an absolute value of the multiplication factor may be set to be greater than 1 or less than 1 so as to provide the current command signal Iₛₕₐᵣₑ in a proper signal format to the power balancing device 30. In other embodiments, other suitable circuit components or detection mechanisms may be used to generate the current command signal Iₛₕₐᵣₑ, for example, using an inductor to sense the output current I_{PSU} to correspondingly generate the current command signal Iₛₕₐᵣₑ.

The power balancing device 30 can determine the load status of the server 10 according to the current command signal Iₛₕₐᵣₑ acquired from the power shelf 20 and perform corresponding discharging and charging operations. In order to be able to respond to the load current change of the server 10 in real time (quickly) and take into account the interference in the fluctuation, the power balancing device 30 may use a low-pass filter with appropriate specifications or other appropriate algorithms to reduce the noise of the current command signal Iₛₕₐᵣₑ. For example, the power balancing device 30 of FIG. 6 includes a noise filtering circuit 31 that performs a moving average calculation on the current command signal Iₛₕₐᵣₑ so that the power balancing device 30 can estimate the load status of the server 10 more accurately. The power balancing device 30 of FIG. 6 includes a noise filtering circuit 31, a control circuit 33, a charging and discharging circuit 35, and an energy storage unit 39. The above-mentioned circuit components, such as the noise filtering circuit 31, the control circuit 33, and the charging and discharging circuit 35, may be implemented as separate circuit components, integrated into one or more circuit components, or implemented by software, firmware, and hardware.

The noise filtering circuit 31 performs moving average or other appropriate algorithm calculation on the current command signal Iₛₕₐᵣₑ output by the power shelf 20, and then provides it to the control circuit 33 to determine whether to enable the charging and discharging circuit 35 to operate. If the control circuit 33 determines that the energy storage unit 39 needs to be charged, the control circuit 33 will output a charging enabled signal CHG_EN to enable the charging and discharging circuit 35 so that the energy storage unit 39 receives electrical energy provided by the power busbar 50 for charging. If the control circuit 33 determines that the energy storage unit 39 needs to be discharged, the control circuit 33 will output a discharging enabled signal DCH_EN to enable the charging and discharging circuit 35 to control the energy storage unit 39 to provide electrical energy to the power busbar 50.

In another embodiment, for processing the current command signal Iₛₕₐᵣₑ, the power balancing device 30 may not include the noise filtering circuit 31 and directly use the current command signal Iₛₕₐᵣₑ output by the power shelf 20 to perform charging and discharging determinations of the power balancing device 30.

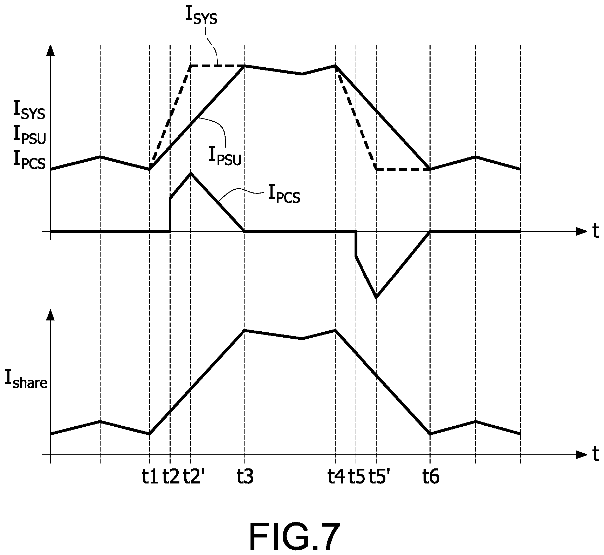

Please refer to FIG. 7, which shows a block circuit diagram of a charging and discharging control of the power balancing device according to an embodiment of the present disclosure. Before time t1, the power supply of the power shelf 20 can instantly follow a loading change rate of the server 10, and therefore only the power shelf 20 provides the output current I_{PSU} to the power busbar 50 to supply power to the server 10. In this condition, since the power balancing device 30 does not provide or receive the adjustment current I_{PCS}, the system current I_{SYS} for supplying power to the server 10 is equal to the output current I_{PSU}. After time t1, the loading of the server 10 starts to increase rapidly, and at time t2, the control circuit 33 of the power balancing device 30 determines that a rising rate (dIₛₕₐᵣₑ/dt) of the current command signal Iₛₕₐᵣₑ exceeds a discharging current threshold I_{th_DCH}. Therefore, the control circuit 33 will output the discharging enabled signal DCH_EN to enable the charging and discharging circuit 35, and the energy storage unit 39 will provide electric energy to the power busbar 50 so that the power balancing device 30 performs a discharging operation and provides the adjustment current I_{PCS} to the server 10 to fill a current difference value (i.e., I_{SYS}-I_{PSU}) between the system current I_{SYS} and the output current I_{PSU} as much as possible, and to provide sufficient power to the server 10 and to allow the power shelf 20 to have enough time to gradually increase the output current I_{PSU} without causing too much impact on the power grid.

After time t1, since the rising rate of the current command signal Iₛₕₐᵣₑ exceeds the discharging current threshold I_{th_DCH}, the control circuit 33 can detect the rapid increase in the loading change of the server 10 in a unit time, and at any time point after the time t1, the discharging enabled signal DCH_EN may be changed to a high level to provide the adjustment current I_{PCS} to the server 10. The figure lines in the embodiment of FIG. 7 are simplified for the convenience of explanation, and the current command signal Iₛₕₐᵣₑ may be a signal with nonlinear variation. In this embodiment, although the loading of the server 10 has increased rapidly after time t1, the time when the current command signal Iₛₕₐᵣₑ changes will be later than the time when the system current I_{SYS} starts to increase the load rapidly. Furthermore, if the power balancing device 30 uses the noise filtering circuit 31 to process the current command signal Iₛₕₐᵣₑ, additional signal processing time will be added. Therefore, the control circuit 33 does not confirm until time t2 that the rising rate of the current command signal Iₛₕₐᵣₑ has exceeded the discharging current threshold I_{th_DCH}, and the power balancing device 30 starts the discharging operation to provide the adjustment current I_{PCS} to the server 10.

At time t2', the loading of the server 10 is maintained at substantially the same level or changes at a slower rate. At this time, the power shelf 20 has gradually increased the output current I_{PSU} to a level closer to the system current I_{SYS} required by the server 10, and therefore at this time, the power balancing device 30 can start to decrease the adjustment current I_{PCS}. At time t3, the power supply of the power shelf 20 can instantly follow the loading change rate of the server 10, and therefore the power shelf 20 provides the output current I_{PSU} to the power busbar 50 to supply power to the server 10, and the power balancing device 30 stops providing the adjustment current I_{PCS}.

During the period from time t3 to time t4, since the loading change rate of the server 10 is relatively smooth, the power shelf 20 provides the output current I_{PSU} to the power busbar 50 to supply power to the server 10, and the power balancing device 30 does not provide or receive the adjustment current I_{PCS}, and therefore the system current I_{SYS} that supplies power to the server 10 is approximately equal to the output current I_{PSU}.

After time t4, the loading of the server 10 decreases rapidly, and at time t5, the control circuit 33 of the power balancing device 30 determines that the falling rate of the current command signal Iₛₕₐᵣₑ exceeds the charging current threshold I_{th_CHG}. Therefore, the power balancing device 30 performs a charging operation and receives the adjustment current I_{PCS} to the power balancing device 30 to fill a current difference value (i.e., I_{PSU}-I_{SYS}) between the output current I_{PSU} and the system current I_{SYS} as much as possible, and allows the power shelf 20 to have enough time to decrease the output current I_{PSU} without causing too much impact on the power grid. In this condition, the charging enabled signal CHG_EN output by the control circuit 33 changes to a high level to enable the charging and discharging circuit 35 so that the energy storage unit 39 of the power balancing device 30 is charged through the power supply of the power shelf 20.

After time t5, since the falling rate (dIₛₕₐᵣₑ/dt) of the current command signal Iₛₕₐᵣₑ exceeds the charging current threshold I_{th_CHG}, the control circuit 33 can detect the rapid decrease in the loading change of the server 10 in a unit time, and at any time point after the time t5, the charging enabled signal CHG_EN may be changed to a high level to receive the adjustment current I_{PCS} to charge the energy storage unit 39. The figure lines in the embodiment of FIG. 7 are simplified for the convenience of explanation, and the current command signal Iₛₕₐᵣₑ may be a signal with nonlinear variation. In this embodiment, although the loading of the server 10 has decreased rapidly after time t4, the time when the current command signal Iₛₕₐᵣₑ changes will be later than the time when the system current I_{SYS} starts to decrease the load rapidly. Furthermore, if the power balancing device 30 uses the noise filtering circuit 31 to process the current command signal Iₛₕₐᵣₑ, additional signal processing time will be added. Therefore, the control circuit 33 does not confirm until time t5 that the falling rate of the current command signal Iₛₕₐᵣₑ has exceeded the charging current threshold I_{th_CHG}, and the power balancing device 30 starts the charging operation to receive the adjustment current I_{PCS} to charge the energy storage unit 39.

At time t5', the loading of the server 10 is maintained at substantially the same level or changes at a slower rate. At this time, the power shelf 20 has gradually decreased the output current I_{PSU} to a level closer to the system current I_{SYS} required by the server 10, and therefore at this time, the power balancing device 30 can start to increase the adjustment current I_{PCS}. At time t6, the power supply of the power shelf 20 can instantly follow the loading change rate of the server 10, and therefore the power shelf 20 provides the output current I_{PSU} to the power busbar 50 to supply power to the server 10, and the power balancing device 30 stops receiving the adjustment current I_{PCS}. After time t6, since the loading change rate of the server 10 is relatively smooth, the power shelf 20 provides the output current I_{PSU} to the power busbar 50 to supply power to the server 10, and the power balancing device 30 does not provide or receive the adjustment current I_{PCS}, and therefore the system current I_{SYS} that supplies power to the server 10 is approximately equal to the output current I_{PSU}.

Therefore, when the rising rate of the current command signal Iₛₕₐᵣₑ exceeds the discharging current threshold I_{th_DCH}, the power balancing device 30 provides the adjustment current I_{PCS} with a suitable value to supply power to the server 10. When the falling rate of the current command signal Iₛₕₐᵣₑ exceeds the charging current threshold I_{th_CHG}, the power balancing device 30 receives the adjustment current I_{PCS} with a suitable value from the power busbar 50 to charge and store energy in the energy storage unit 39, thereby maintaining the power supply stability of the power shelf 20. Therefore, during the loading operation of the server 10, if the loading change rate of the server 10 does not increase or decrease rapidly, the power balancing device 30 may be in an idle state, and the power shelf 20 may alone provide the output current I_{PSU} as the system current I_{SYS} required by the server 10. In another embodiment, if the loading change rate of the server 10 does not increase or decrease rapidly, the power balancing device 30 may also use the adjustment current I_{PCS} with a suitable value to charge or discharge the energy storage unit 39 to a suitable amount of electricity.

In the above-mentioned embodiments, the waveform of the adjustment current I_{PCS} provided or received by the power balancing device 30 is only one possible implementation. In other embodiments, the adjustment current I_{PCS} may also be set to a desired current value according to parameters such as the charging and discharging speed of the energy storage unit 39 and the storage capacity of the energy storage unit 39. In one embodiment, the energy storage unit 39 may not be able to quickly and completely compensate for a current difference value (i.e., I_{SYS}-I_{PSU}) between the required system current I_{SYS} and the output current I_{PSU}, or completely receive the excess current between the output current I_{PSU} and the required system current I_{SYS} (i.e., I_{PSU}-I_{SYS}). However, the power supply operation and charging operation provided by the power balancing device 30 can still maintain the power supply stability of the power shelf 20 and its upstream power grid.

In another embodiment, the power balancing device 30 may also be configured to perform charging operation or discharging operation according to the storage capacity of the energy storage unit 39 at an appropriate time. For example, during the period from time t3 to time t4 in FIG. 7, if the storage capacity of the energy storage unit 39 is too low, the control circuit 33 may receive part of the current from the output current I_{PSU} to charge the energy storage unit 39 without affecting to supply the system current I_{SYS}. In another embodiment, the control circuit 33 may also determine the current value of the adjustment current I_{PCS} provided or received according to the storage capacity of the energy storage unit 39 so that the storage capacity of the energy storage unit 39 can provide power supply operation and charging operation for a long time, thereby maintaining the power supply stability of the power shelf 20 and its upstream power grid.

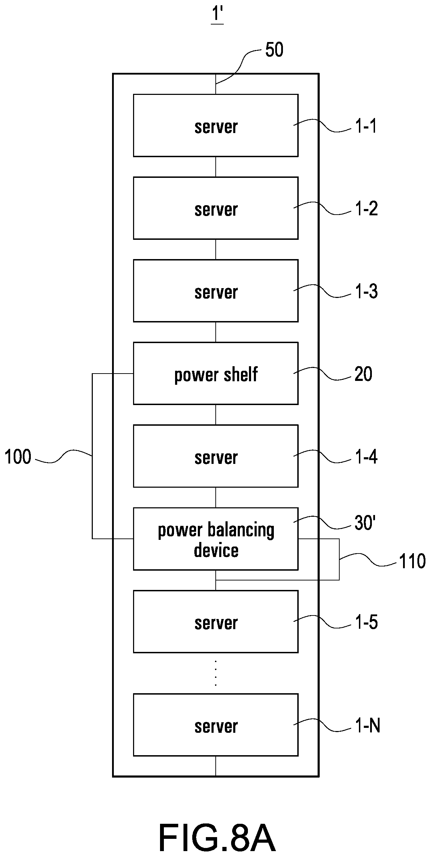

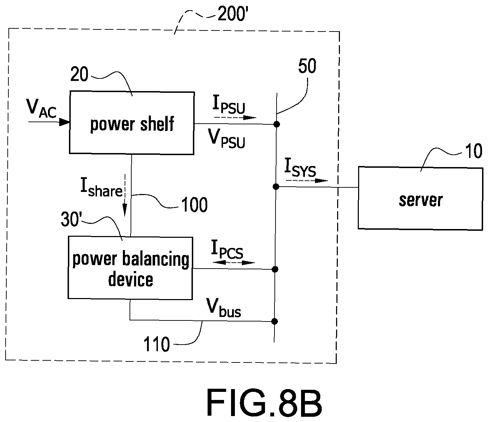

Please refer to FIG. 8A, which shows a schematic diagram of the rack according to another embodiment of the present disclosure, and please refer to FIG. 8B, which shows a block diagram of the rack-based power system according to another embodiment of the present disclosure. The connection relationship and operation mode of a plurality of servers 1-1 to 1-N, the power shelf 20, and the power balancing device 30' installed in the rack 1' of the embodiment of FIG. 8A are the same or similar to those of the rack 1 in FIG. 1. In the embodiment of FIG. 8A, the rack 1' further includes a second signal wire 110, and the power balancing device 30' acquires a bus voltage signal V_{bus} on the power busbar 50 through the second signal wire 110 to acquire the voltage information on the power busbar 50. In one embodiment, the bus voltage signal V_{bus} is a signal that is positively correlated with a voltage value on the power busbar 50. The power balancing device 30' acquires the voltage information on the power busbar 50 through the bus voltage signal V_{bus}, and further estimates the load status of the server. A first terminal of the second signal wire 110 is connected to the power balancing device 30', and a second terminal thereof is connected to an appropriate position of the power busbar 50. For example, the position of the power busbar 50 may be close to where the power balancing device 30' is configured to acquire a proximal voltage, close to the position of certain servers with a larger change in power consumption, or far away from where the power balancing device 30' is configured to acquire a remote voltage (such as other racks).

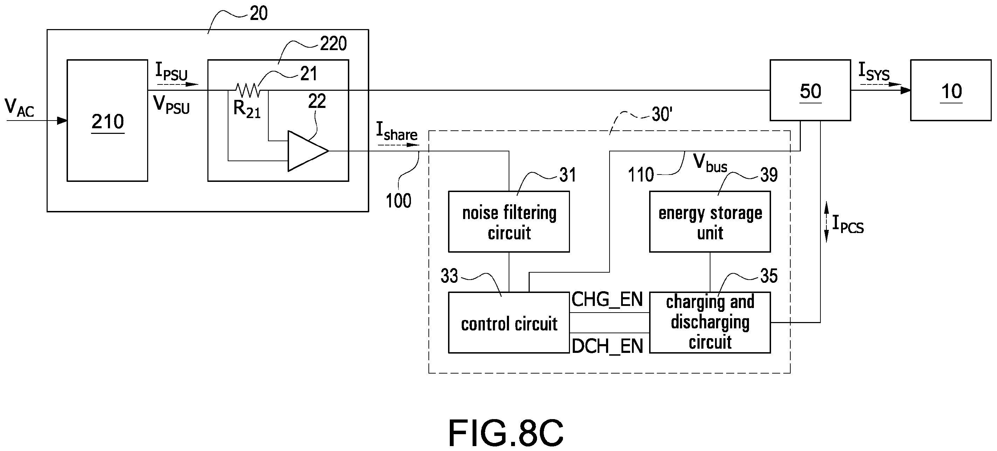

FIG. 8C shows a block circuit diagram of the power supply unit of the power shelf and the power balancing device according to another embodiment of the present disclosure. The connection relationship and operation mode of most components of the embodiment of FIG. 8C are the same or similar to those of the embodiment of FIG. 6. In this embodiment, the power balancing device 30' can acquire the bus voltage signal V_{bus} on the power busbar 50 through the second signal wire 110 to acquire the voltage information on the power busbar 50. Furthermore, the bus voltage signal V_{bus} is received by the control circuit 33 so that the control circuit 33 determines whether to enable the charging and discharging circuit 35 to operate according to the bus voltage signal V_{bus}. If the control circuit 33 determines that the energy storage unit 39 needs to be charged, the control circuit 33 will output a charging enabled signal CHG_EN to enable the charging and discharging circuit 35 so that the energy storage unit 39 receives electrical energy provided by the power busbar 50 for charging. If the control circuit 33 determines that the energy storage unit 39 needs to be discharged, the control circuit 33 will output a discharging enabled signal DCH_EN to enable the charging and discharging circuit 35 to control the energy storage unit 39 to provide electrical energy to the power busbar 50.

Another embodiment of the present disclosure may determine whether to enable the charging and discharging circuit 35 to operate only according to the bus voltage signal V_{bus} (without using the current command signal Iₛₕₐᵣₑ for determination), and therefore the contents related to the current command signal Iₛₕₐᵣₑ shown in FIG. 8C can be omitted. That is, the components and circuits related to the first signal wire 100, the noise filtering circuit 31, etc. may be omitted, and only the contents related to the bus voltage signal V_{bus} may be retained.

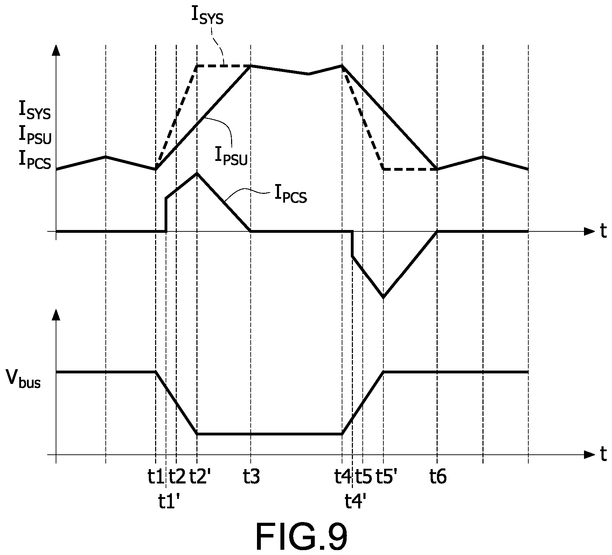

Please refer to FIG. 9, which shows a block circuit diagram of a charging and discharging control of the power balancing device in FIG. 8C according to an embodiment of the present disclosure. This embodiment only uses the bus voltage signal V_{bus}, and does not use the current command signal Iₛₕₐᵣₑ for determination. Before time t1, the power supply of the power shelf 20 can instantly follow a loading change rate of the server 10, and therefore only the power shelf 20 provides the output current I_{PSU} to the power busbar 50 to supply power to the server 10. In this condition, since the power balancing device 30' does not provide or receive the adjustment current I_{PCS}, the system current I_{SYS} for supplying power to the server 10 is equal to the output current I_{PSU}. After time t1, the loading of the server 10 starts to increase rapidly, and at time t1', the control circuit 33 of the power balancing device 30' determines that a falling rate (dV_{bus}/dt) of the bus voltage signal V_{bus} exceeds a discharging voltage threshold V_{th_DCH}. Therefore, the control circuit 33 will output the discharging enabled signal DCH_EN to enable the charging and discharging circuit 35, and the energy storage unit 39 will provide electric energy to the power busbar 50 so that the power balancing device 30' performs a discharging operation and provides the adjustment current I_{PCS} to the server 10 to fill a current difference value (i.e., I_{SYS}-I_{PSU}) between the system current I_{SYS} and the output current I_{PSU} as much as possible, and to provide sufficient power to the server 10 and to allow the power shelf 20 to have enough time to gradually increase the output current I_{PSU} without causing too much impact on the power grid.

After time t1', since the falling rate of the bus voltage signal V_{bus} exceeds the discharging voltage threshold V_{th_DCH}, the control circuit 33 can detect the rapid increase in the loading change of the server 10 in a unit time, and at any time point after the time t1', the discharging enabled signal DCH_EN may be changed to a high level to provide the adjustment current I_{PCS} to the server 10. The figure lines in the embodiment of FIG. 9 are simplified for the convenience of explanation, and the bus voltage signal V_{bus} may be a signal with nonlinear variation.

At time t2', the loading of the server 10 is maintained at substantially the same level or changes at a slower rate. At this time, the power shelf 20 has gradually increased the output current I_{PSU} to a level closer to the system current I_{SYS} required by the server 10, and therefore at this time, the power balancing device 30' can start to decrease the adjustment current I_{PCS}. At time t3, the power supply of the power shelf 20 can instantly follow the loading change rate of the server 10, and therefore the power shelf 20 provides the output current I_{PSU} to the power busbar 50 to supply power to the server 10, and the power balancing device 30' stops providing the adjustment current I_{PCS}.

During the period from time t3 to time t4, since the loading change rate of the server 10 is relatively smooth, the power shelf 20 provides the output current I_{PSU} to the power busbar 50 to supply power to the server 10, and the power balancing device 30' does not provide or receive the adjustment current I_{PCS}, and therefore the system current I_{SYS} that supplies power to the server 10 is approximately equal to the output current I_{PSU}.

After time t4, the loading of the server 10 decreases rapidly, and at time t4', the control circuit 33 of the power balancing device 30' determines that the rising rate of the bus voltage signal V_{bus} exceeds the charging voltage threshold V_{th_CHG}. Therefore, the power balancing device 30' performs a charging operation and receives the adjustment current I_{PCS} to the power balancing device 30' to fill a current difference value (i.e., I_{PSU}-I_{SYS}) between the output current I_{PSU} and the system current I_{SYS} as much as possible, and allows the power shelf 20 to have enough time to decrease the output current I_{PSU} without causing too much impact on the power grid. In this condition, the charging enabled signal CHG_EN output by the control circuit 33 changes to a high level to enable the charging and discharging circuit 35 so that the energy storage unit 39 of the power balancing device 30' is charged through the power supply of the power shelf 20.

After time t4', since the rising rate (dV_{bus}/dt) of the bus voltage signal V_{bus} exceeds the charging voltage threshold V_{th_CHG}, the control circuit 33 can detect the rapid decrease in the loading change of the server 10 in a unit time, and at any time point after the time t4', the charging enabled signal CHG_EN may be changed to a high level to receive the adjustment current I_{PCS} to charge the energy storage unit 39. The figure lines in the embodiment of FIG. 9 are simplified for the convenience of explanation, and the bus voltage signal V_{bus} may be a signal with nonlinear variation.

At time t5', the loading of the server 10 is maintained at substantially the same level or changes at a slower rate. At this time, the power shelf 20 has gradually decreased the output current I_{PSU} to a level closer to the system current I_{SYS} required by the server 10, and therefore at this time, the power balancing device 30' can start to increase the adjustment current I_{PCS}. At time t6, the power supply of the power shelf 20 can instantly follow the loading change rate of the server 10, and therefore the power shelf 20 provides the output current I_{PSU} to the power busbar 50 to supply power to the server 10, and the power balancing device 30' stops receiving the adjustment current I_{PCS}. After time t6, since the loading change rate of the server 10 is relatively smooth, the power shelf 20 provides the output current I_{PSU} to the power busbar 50 to supply power to the server 10, and the power balancing device 30' does not provide or receive the adjustment current I_{PCS}, and therefore the system current I_{SYS} that supplies power to the server 10 is approximately equal to the output current I_{PSU}.

Therefore, when the falling rate of the bus voltage signal V_{bus} exceeds the discharging voltage threshold V_{th_DCH}, the power balancing device 30' provides the adjustment current I_{PCS} with a suitable value to supply power to the server 10. When the rising rate of the bus voltage signal V_{bus} exceeds the charging voltage threshold V_{th_CHG}, the power balancing device 30' receives the adjustment current I_{PCS} with a suitable value from the power busbar 50 to charge and store energy in the energy storage unit 39, thereby maintaining the power supply stability of the power shelf 20. Therefore, during the loading operation of the server 10, if the loading change rate of the server 10 does not increase or decrease rapidly, the power balancing device 30' may be in an idle state, and the power shelf 20 may alone provide the output current I_{PSU} as the system current I_{SYS} required by the server 10. In another embodiment, if the loading change rate of the server 10 does not increase or decrease rapidly, the power balancing device 30' may also use the adjustment current I_{PCS} with a suitable value to charge or discharge the energy storage unit 39 to a suitable amount of electricity.

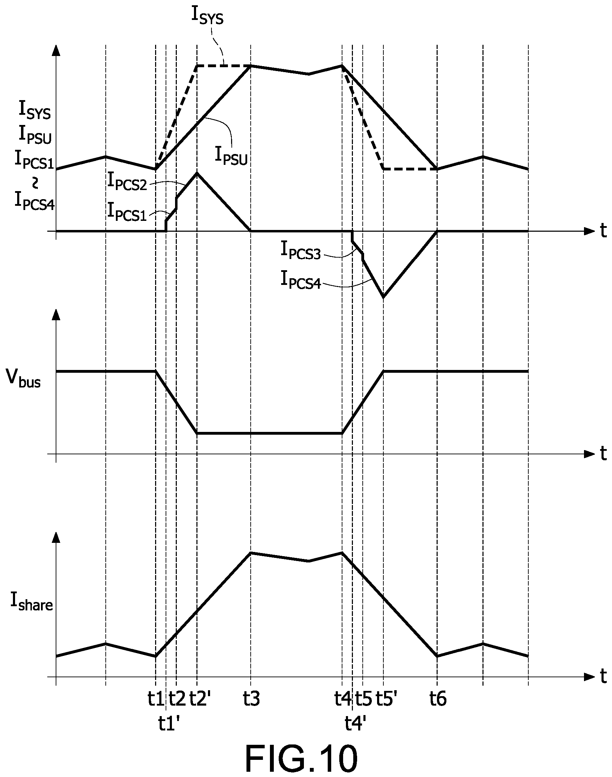

Please refer to FIG. 10, which shows a block circuit diagram of a charging and discharging control of the power balancing device in FIG. 8C according to another embodiment of the present disclosure. In this embodiment, the power balancing device 30' uses the bus voltage signal V_{bus} and the current command signal Iₛₕₐᵣₑ to determine whether the loading is increasing or decreasing rapidly. At time t1', since the falling rate of the bus voltage signal V_{bus} exceeds the discharging voltage threshold V_{th_DCH}, the control circuit 33 determines that the loading change rate of the server 10 increases rapidly according to the falling rate of the bus voltage signal V_{bus}. Therefore, at time t1', the power balancing device 30' provides a first adjustment current I_{PCS1} to partially compensate for a current difference value (I_{SYS}-I_{PSU}), that is, I_{PCS1}=k₁*(I_{SYS}-I_{PSU}), where k₁ is a positive number less than 1. At time t2, since the rising rate of the current command signal Iₛₕₐᵣₑ has exceeded the discharging current threshold I_{th_DCH}, it is more certain that the loading change rate will increase rapidly. Therefore, the power balancing device 30' provides a second adjustment current I_{PCS2} for the discharging operation, wherein I_{PCS2}=k₂*(I_{SYS}-I_{PSU}), for example, k₂ is set to 1 to provide an adjustment current of the difference of I_{SYS}-I_{PSU} to the server 10, wherein k₂>k₁ so that the second adjustment current I_{PCS2} is greater than the first adjustment current I_{PCS1}. Since the bus voltage signal V_{bus} reacts faster to the load status but may be more prone to misjudgment (for example, a loading change that lasts only a short time), the first adjustment current I_{PCS1} is first provided during the period from time t1' to time t2. If the subsequent loading continues to increase, part of the current difference may be compensated in advance. If there is a misjudgment, it will not have a big impact on the system. After the current command signal Iₛₕₐᵣₑ is determined to be more accurate, a larger second adjustment current I_{PCS2} is then provided for power supply.

Similarly, at time t4', since the rising rate of the bus voltage signal V_{bus} exceeds the charging voltage threshold V_{th_CHG}, the control circuit 33 determines that the loading change rate of the server 10 decreases rapidly according to the rising rate of the bus voltage signal V_{bus}. Therefore, at time t4', the power balancing device 30' provides a third adjustment current I_{PCS3} to partially compensate for a current difference value (I_{PSU}-I_{SYS}), that is, I_{PCS3}=k₃*(I_{PSU}-I_{SYS}), where k₃ is a positive number less than 1. At time t5, since the falling rate of the current command signal Iₛₕₐᵣₑ has exceeded the charging current threshold I_{th_CHG}, it is more certain that the loading change rate will decrease rapidly. Therefore, the power balancing device 30' provides a fourth adjustment current I_{PCS4} for the charging operation, wherein I_{PCS4}=k₄*(I_{PSU}-I_{SYS}), for example, k₄ is set to 1 to provide an adjustment current of the difference of I_{PSU}-I_{SYS} to the energy storage unit 39, wherein k₄>k₃ so that the fourth adjustment current I_{PCS4} is greater than the third adjustment current I_{PCS3}. Since the bus voltage signal V_{bus} reacts faster to the load status but may be more prone to misjudgment (for example, a loading change that lasts only a short time), the third adjustment current I_{PCS3} is first provided during the period from time t4' to time t5. If the subsequent loading continues to increase, part of the current difference may be compensated in advance. If there is a misjudgment, it will not have a big impact on the system. After the current command signal Iₛₕₐᵣₑ is determined to be more accurate, a larger fourth adjustment current I_{PCS4} is then provided.

In the above-mentioned embodiments, whether based on the current command signal Iₛₕₐᵣₑ alone, based on the bus voltage signal V_{bus} alone, or based on the current command signal Iₛₕₐᵣₑ and the bus voltage signal V_{bus} together, the control circuit of the power balancing device can determine the current value of the provided or received adjustment current according to appropriate conditions. For example, the values of k₁ to k₄ are determined according to one or more parameters such as the storage capacity of the energy storage unit, the ripple specification of the AC input voltage V_{AC}, historical statistical data, etc. In one embodiment, in response to the maximum ripple of 10% on the AC input voltage V_{AC} caused by rapid loading change of the server, the control circuit of the power balancing device can provide or receive an adjustment current I_{PCS} that is an appropriate proportion (which can be set to be greater than 1 or less than 1, respectively) of the current difference between the system current I_{SYS} and the output current I_{PSU} so that the ripple specification on the AC input voltage V_{AC} meets the required requirements.

In the above-mentioned embodiment, the rising rate and the falling rate of the current command signal Iₛₕₐᵣₑ, the rising rate and the falling rate of the bus voltage signal V_{bus}, the discharging current threshold I_{th_DCH}, the charging current threshold I_{th_CHG}, the discharging voltage threshold V_{th_DCH}, and the charging voltage threshold V_{th_CHG} may be expressed in an appropriate format to determine whether the loading change rate of the server 10 exceeds the thresholds and whether the power balancing device 30,30' provides or receives the adjustment current I_{PCS}. For example, the rising/falling rate of the current command signal Iₛₕₐᵣₑ, the discharging current threshold I_{th_DCH}, and the charging current threshold I_{th_CHG} are all compared with absolute values to determine the loading change rate of the server 10. In another embodiment, the falling rate of the current command signal Iₛₕₐᵣₑ and the charging current threshold I_{th_CHG} are both negative values. When the falling rate of the current command signal Iₛₕₐᵣₑ (for example, -5V/ms) is less than the charging current threshold I_{th_CHG} (for example, -3V/ms), the control circuit determines that the falling rate of the current command signal Iₛₕₐᵣₑ exceeds the charging current threshold I_{th_CHG}. The same also applies to the operation of the bus voltage signal V_{bus}.

Accordingly, the present disclosure has the following features and advantages: the power balancing device 30,30' can determine the load status of the server 10 according to at least one of the current command signal Iₛₕₐᵣₑ acquired from the power shelf 20 and the bus voltage signal V_{bus} acquired from the power busbar 50. During the loading operation of the server 10, when the loading change rate increases rapidly so that the rising rate of the current command signal Iₛₕₐᵣₑ exceeds the discharging current threshold I_{th_DCH}, and/or the falling rate of the bus voltage signal V_{bus} exceeds the discharging voltage threshold V_{th_DCH}, the power balancing device 30,30' supplies power to the server 10. During the loading operation of the server 10, when the loading change rate decreases rapidly so that the falling rate of the current command signal Iₛₕₐᵣₑ exceeds the charging current threshold I_{th_CHG}, and/or the rising rate of the bus voltage signal V_{bus} exceeds the charging voltage threshold V_{th_CHG}, the power shelf 20 charges the power balancing device 30,30', thereby maintaining the power supply stability of the power shelf 20 and its upstream power grid. Therefore, the present disclosure uses at least one of the bus voltage signal V_{bus} and the current command signal Iₛₕₐᵣₑ as a determination on whether the power balancing device 30,30' is in a charging operation or a discharging operation. The bus voltage signal V_{bus} can be used to make instant, fast and non-delayed determinations on the loading status, while the current command signal Iₛₕₐᵣₑ can be used to make stable determinations on the loading status. Therefore, using the bus voltage signal V_{bus} and the current command signal Iₛₕₐᵣₑ at the same time can have the advantages of both.

As will become apparent to the skilled person when studying the above disclosure, the subject-matter of the appended claims can also be combined in a different manner as specifically claimed. In particular the term "according to claim 1" and similar shall be deemed to encompass also the meaning "according to any of the preceding (antecedent) claims".

## Claims

1. A power balancing device (30,30') configured to be coupled to a server (10) and a power shelf (20) through a power busbar (50), comprising:
a control circuit (33) configured to receive a bus voltage signal (V_{bus}) from the power busbar (50), wherein the bus voltage signal (V_{bus}) is positively correlated with a current value of an output current (I_{PSU}) generated by the power shelf (20),
a charging and discharging circuit (35) coupled to the control circuit (33), and configured to receive a discharging enabled signal (DCH_EN) and a charging enabled signal (CHG_EN) generated by the control circuit (33), and
an energy storage unit (39) coupled to the charging and discharging circuit (35),
wherein when the control circuit (33) determines that a falling rate of the bus voltage signal (V_{bus}) exceeds a discharging voltage threshold (V_{th_DCH}), the control circuit (33) generates the discharging enabled signal (DCH_EN) so that the charging and discharging circuit (35) is accordingly configured to control the energy storage unit (39) to provide a first adjustment current (I_{PCS1}) to the power busbar (50) to supply power,
wherein when the control circuit (33) determines that a rising rate of the bus voltage signal (V_{bus}) exceeds a charging voltage threshold (V_{th_CHG}), the control circuit (33) generates the charging enabled signal (CHG_EN) so that the charging and discharging circuit (35) is accordingly configured to receive a third adjustment current (I_{PCS3}) from the power busbar (50) to charge the energy storage unit (39).

2. The power balancing device (30,30') as claimed in claim 1, wherein when the charging and discharging circuit (35) controls the energy storage unit (39) to provide the first adjustment current (I_{PCS1}) to the power busbar (50), a magnitude of a system current (I_{SYS}) for supplying power to the server (10) is equal to a magnitude of the output current (I_{PSU}) plus a magnitude of the first adjustment current (I_{PCS1}); when the charging and discharging circuit (35) receives the third adjustment current (I_{PCS3}) from the power busbar (50) to charge the energy storage unit (39), the magnitude of the third adjustment current (I_{PCS3}) is equal to the magnitude of the output current (I_{PSU}) minus the magnitude of the system current (I_{SYS}).

3. The power balancing device (30,30') as claimed in claim 1, wherein the control circuit (33) is configured to receive a current command signal (Iₛₕₐᵣₑ) from the power shelf (20), wherein the current command signal (Iₛₕₐᵣₑ) is positively correlated with the current value of the output current (I_{PSU}) generated by the power shelf (20),
wherein after the energy storage unit (39) provides the first adjustment current (I_{PCS1}) to the power busbar (50) to supply power, when the control circuit (33) determines that a rising rate of the current command signal (Iₛₕₐᵣₑ) exceeds a discharging current threshold (I_{th_DCH}), the charging and discharging circuit (35) is configured to control the energy storage unit (39) to provide a second adjustment current (I_{PCS2}) to the power busbar (50) to supply power, wherein the second adjustment current (I_{PCS2}) is greater than the first adjustment current (I_{PCS1}),
wherein after the charging and discharging circuit (35) receives the third adjustment current (I_{PCS3}) from the power busbar (50) to charge the energy storage unit (39), when the control circuit (33) determines that a falling rate of the current command signal (Iₛₕₐᵣₑ) exceeds a charging current threshold (I_{th_CHG}), the charging and discharging circuit (35) is configured to receive a fourth adjustment current (I_{PCS4}) from the power busbar (50) to charge the energy storage unit (39), wherein the fourth adjustment current (I_{PCS4}) is greater than the third adjustment current (I_{PCS3}).

4. The power balancing device (30,30') as claimed in claim 3, wherein a magnitude of the first adjustment current (I_{PCS1}) is equal to k₁ times a difference between a magnitude of a system current (I_{SYS}) for supplying power to the server (10) and a magnitude of the output current (I_{PSU}): I_{PCS1}=k₁*(I_{SYS}-I_{PSU}), where k₁ is a positive number less than 1, I_{PCS1} is the first adjustment current (I_{PCS1}), I_{SYS} is the system current (I_{SYS}), I_{PSU} is the output current (I_{PSU}); a magnitude of the second adjustment current (I_{PCS2}) is equal to k₂ times a difference between the magnitude of the system current (I_{SYS}) and the magnitude of the output current (I_{PSU}): I_{PCS2}=k₂*(I_{SYS}-I_{PSU}), where k₂>k₁, I_{PCS2} is the second adjustment current (I_{PCS2}); a magnitude of the third adjustment current (I_{PCS3}) is equal to k₃ times a difference between the magnitude of the output current (I_{PSU}) and the magnitude of the system current (I_{SYS}) I_{PCS3}=k₃*(I_{PSU}-I_{SYS}), where k₃ is a positive number less than 1, I_{PCS3} is the third adjustment current (I_{PCS3}); a magnitude of the fourth adjustment current (I_{PCS4}) is equal to k₄ times a difference between the magnitude of the output current (I_{PSU}) and the magnitude of the system current (I_{SYS}) I_{PCS4}=k₄*(I_{PSU}-I_{SYS}), where k₄>k₃, I_{PCS4} is the fourth adjustment current (I_{PCS4}).

5. A rack-based power system configured to supply power to a server (10) through a power busbar (50), comprising:
a power shelf (20) configured to receive an input power source, and convert the input power source to provide an output current (I_{PSU}) to the power busbar (50) so that the power busbar (50) accordingly transmits a system current (I_{SYS}) to supply power to the server (10), and
a power balancing device (30,30') configured to electrically connect to the power busbar (50),
wherein the power balancing device (30,30') is configured to receive a bus voltage signal (V_{bus}) from the power busbar (50) through a second signal wire (110), wherein the bus voltage signal (V_{bus}) is positively correlated with a current value of the output current (I_{PSU}),
wherein when the power balancing device (30,30') determines that a falling rate of the bus voltage signal (V_{bus}) exceeds a discharging voltage threshold (V_{th_DCH}), the power balancing device (30,30') is configured to provide a first adjustment current (I_{PCS1}) to the power busbar (50) to supply power to the server (10) together with the power shelf (20),
wherein when the power balancing device (30,30') determines that a rising rate of the bus voltage signal (V_{bus}) exceeds a charging voltage threshold (V_{th_CHG}), the power balancing device (30,30') is configured to receive a third adjustment current (I_{PCS3}) from the power busbar (50).

6. The rack-based power system as claimed in claim 5, wherein when the power balancing device (30,30') provides the first adjustment current (I_{PCS1}) to the power busbar (50), a magnitude of the system current (I_{SYS}) is equal to a magnitude of the output current (I_{PSU}) plus a magnitude of the first adjustment current (I_{PCS1}); when the power balancing device (30,30') receives the third adjustment current (I_{PCS3}) from the power busbar (50), a magnitude of the third adjustment current (I_{PCS3}) is equal to the magnitude of the output current (I_{PSU}) minus the magnitude of the system current (I_{SYS}).

7. The rack-based power system as claimed in claim 5, wherein the power balancing device (30,30') is configured to receive a current command signal (Iₛₕₐᵣₑ) from the power shelf (20) through a first signal wire (100), wherein the current command signal (Iₛₕₐᵣₑ) is positively correlated with a current value of an output current (I_{PSU}) generated by the power shelf (20),
wherein after the power balancing device (30,30') provides the first adjustment current (I_{PCS1}) to the power busbar (50) to supply power, when the power balancing device (30,30') determines that a rising rate of the current command signal (Iₛₕₐᵣₑ) exceeds a discharging current threshold (I_{th_DCH}), the power balancing device (30,30') is configured to provide a second adjustment current (I_{PCS2}) to the power busbar (50) to supply power, wherein the second adjustment current (I_{PCS2}) is greater than the first adjustment current (I_{PCS1}),
wherein after the power balancing device (30,30') receives the third adjustment current (I_{PCS3}) from the power busbar (50), when the power balancing device (30,30') determines that a falling rate of the current command signal (Iₛₕₐᵣₑ) exceeds a charging current threshold (I_{th_CHG}), the power balancing device (30,30') is configured to receive a fourth adjustment current (I_{PCS4}) from the power busbar (50), wherein the fourth adjustment current (I_{PCS4}) is greater than the third adjustment current (I_{PCS3}).

8. The rack-based power system as claimed in claim 7, wherein a magnitude of the first adjustment current (I_{PCS1}) is equal to k₁ times a difference between a magnitude of the system current (I_{SYS}) and a magnitude of the output current (I_{PSU}): I_{PCS1}=k₁*(I_{SYS}-I_{PSU}), where k₁ is a positive number less than 1, I_{PCS1} is the first adjustment current (I_{PCS1}), I_{SYS} is the system current (I_{SYS}), I_{PSU} is the output current (I_{PSU}); a magnitude of the second adjustment current (I_{PCS2}) is equal to k₂ times a difference between the magnitude of the system current (I_{SYS}) and the magnitude of the output current (I_{PSU}): I_{PCS2}=k₂*(I_{SYS}-I_{PSU}), where k₂>k₁, I_{PCS2} is the second adjustment current (I_{PCS2}); a magnitude of the third adjustment current (I_{PCS3}) is equal to k₃ times a difference between the magnitude of the output current (I_{PSU}) and the magnitude of the system current (I_{SYS}) I_{PCS3}=k₃*(I_{PSU}-I_{SYS}), where k₃ is a positive number less than 1, I_{PCS3} is the third adjustment current (I_{PCS3}); a magnitude of the fourth adjustment current (I_{PCS4}) is equal to k₄ times a difference between the magnitude of the output current (I_{PSU}) and the magnitude of the system current (I_{SYS}) I_{PCS4}=k₄*(I_{PSU}-I_{SYS}), where k₄>k₃, I_{PCS4} is the fourth adjustment current (I_{PCS4}).

9. A power balancing method configured to control a power balancing device (30,30'), the power balancing device (30,30') configured to be coupled to a server (10) and a power shelf (20) through a power busbar (50), comprising:
receiving, by the power balancing device (30,30'), a bus voltage signal (V_{bus}) from the power busbar (50), wherein the bus voltage signal (V_{bus}) is positively correlated with a current value of an output current (I_{PSU}) generated by the power shelf (20),
controlling, by a control circuit (33) of the power balancing device (30,30'), a charging and discharging circuit (35) to configure an energy storage unit (39) of the power balancing device (30,30') to provide a first adjustment current (I_{PCS1}) to the power busbar (50) to supply power when the power balancing device (30,30') determines that a falling rate of the bus voltage signal (V_{bus}) exceeds a discharging voltage threshold (V_{th_DCH}),
controlling, by the control circuit (33) of the power balancing device (30,30'), the charging and discharging circuit (35) of the power balancing device (30,30') to receive a third adjustment current (I_{PCS3}) from the power busbar (50) to charge the energy storage unit (39) when the power balancing device (30,30') determines that a rising rate of the bus voltage signal (V_{bus}) exceeds a charging voltage threshold (V_{th_CHG}).

10. The power balancing method as claimed in claim 9, wherein when the power balancing device (30,30') provides the first adjustment current (I_{PCS1}) to the power busbar (50), a magnitude of the system current (I_{SYS}) for supplying power to the server (10) is equal to a magnitude of the output current (I_{PSU}) plus a magnitude of the first adjustment current (I_{PCS1}); when the power balancing device (30,30') receives the third adjustment current (I_{PCS3}) from the power busbar (50), a magnitude of the third adjustment current (I_{PCS3}) is equal to the magnitude of the output current (I_{PSU}) minus the magnitude of the system current (I_{SYS}).

11. The power balancing method as claimed in claim 9, further comprising:
receiving, by the power balancing device (30,30'), a current command signal (Iₛₕₐᵣₑ) from the power shelf (20), wherein the current command signal (Iₛₕₐᵣₑ) is positively correlated with a current value of the output current (I_{PSU}) generated by the power shelf (20),
wherein after the energy storage unit (39) of the power balancing device (30,30') provides the first adjustment current (I_{PCS1}) to the power busbar (50) to supply power, when the power balancing device (30,30') determines that a rising rate of the current command signal (Iₛₕₐᵣₑ) exceeds a discharging current threshold (I_{th_DCH}), the power balancing device (30,30') is configured to provide a second adjustment current (I_{PCS2}) to the power busbar (50) to supply power, wherein the second adjustment current (I_{PCS2}) is greater than the first adjustment current (I_{PCS1}),
wherein after the charging and discharging circuit (35) of the power balancing device (30,30') receives the third adjustment current (I_{PCS3}) from the power busbar (50), when the power balancing device (30,30') determines that a falling rate of the current command signal (Iₛₕₐᵣₑ) exceeds a charging current threshold (I_{th_CHG}), the power balancing device (30,30') is configured to receive a fourth adjustment current (I_{PCS4}) from the power busbar (50), wherein the fourth adjustment current (I_{PCS4}) is greater than the third adjustment current (I_{PCS3}).

12. The power balancing method as claimed in claim 11, wherein a magnitude of the first adjustment current (I_{PCS1}) is equal to k₁ times a difference between a magnitude of a system current (I_{SYS}) for supplying power to the server (10) and a magnitude of the output current (I_{PSU}): I_{PCS1}=k₁*(I_{SYS}-I_{PSU}), where k₁ is a positive number less than 1, I_{PCS1} is the first adjustment current (I_{PCS1}), I_{SYS} is the system current (I_{SYS}), I_{PSU} is the output current (I_{PSU}); a magnitude of the second adjustment current (I_{PCS2}) is equal to k₂ times a difference between the magnitude of the system current (I_{SYS}) and the magnitude of the output current (I_{PSU}): I_{PCS2}=k₂*(I_{SYS}-I_{PSU}), where k₂>k₁, I_{PCS2} is the second adjustment current (I_{PCS2}); a magnitude of the third adjustment current (I_{PCS3}) is equal to k₃ times a difference between the magnitude of the output current (I_{PSU}) and the magnitude of the system current (I_{SYS}) I_{PCS3}=k₃*(I_{PSU}-I_{SYS}), where k₃ is a positive number less than **1,** I_{PCS3} is the third adjustment current (I_{PCS3}); a magnitude of the fourth adjustment current (I_{PCS4}) is equal to k₄ times a difference between the magnitude of the output current (I_{PSU}) and the magnitude of the system current (I_{SYS}) I_{PCS4}=k₄*(I_{PSU}-I_{SYS}), where k₄>k₃, I_{PCS4} is the fourth adjustment current (I_{PCS4}).
